# FASCICULE DE BREVET EUROPEEN

(11) **EP 4 006 494 B1**
(45) Date de publication et mention de la délivrance du brevet: **13.09.2023**
(21) Numéro de dépôt: 21210586.0
(22) Date de dépôt: 25.11.2021
(51) Int. Cl.: G01D 5/14, G01D 11/30, G01R 33/06, G01R 33/07, G01R 33/09, G01D 11/24

(54) **CAPTEUR APTE À DÉTECTER LE CHAMP MAGNÉTIQUE D'UN CODEUR À DISTANCE D'ENTREFER**
SENSOR ZUR ERFASSUNG DES MAGNETFELDS EINES KODIERERS IM ABSTAND EINES SPALTS
SENSOR CAPABLE OF DETECTING THE MAGNETIC FIELD OF A REMOTE ENCODER OF AN AIR GAP

(30) Priorité: 27.11.2020 FR 2012265
(43) Date de publication de la demande: 01.06.2022
(73) Titulaire: NTN-SNR ROULEMENTS, 74000 Annecy (FR)
(72) Inventeur: DUNOYER, Aymeric, 74010 Annecy (FR)
(74) Mandataire: Sayettat, Julien Christian

(56) Documents cités:
- WO-A2-2006/064169
- WO-A2-2006/064169
- DE-A1-102007 018 758
- DE-A1-102007 018 758
- DE-A1-102017 104 206
- DE-A1-102017 104 206
- DE-A1-102017 212 039
- DE-A1-102017 212 039
- FR-A1- 3 007 845
- FR-A1- 3 007 845
- US-A1- 2016 320 216
- US-A1- 2016 320 216

## Description

L'invention concerne un capteur comprenant un composant sensible apte à détecter le champ magnétique délivré par le déplacement d'un codeur disposé à distance d'entrefer, ainsi qu'un ensemble comprenant un organe mobile équipé d'un tel codeur et monté en déplacement par rapport à une structure fixe équipée d'un tel capteur.

Elle s'applique en particulier à une machine électrique comprenant un tel ensemble, un système de détermination d'au moins une information relative au déplacement de l'organe mobile, ainsi qu'un système d'alimentation électrique qui est géré par ladite information.

Dans une application particulière, la machine est alimentée en électricité pour actionner l'entraînement en déplacement de l'organe mobile, par exemple dans le but de motoriser un dispositif appartenant à une unité d'aide à la conduite d'un véhicule automobile, ou un véhicule à guidage automatique. Dans une autre application, la machine génère de l'électricité par déplacement de l'organe mobile afin de pouvoir alimenter le système.

Dans ce type de machine électrique, on peut souhaiter connaître en temps réel et avec une fiabilité optimale au moins une information relative au déplacement de l'organe mobile, par exemple un paramètre tel que sa position, sa vitesse, son accélération ou son sens de déplacement, notamment afin de pouvoir piloter l'alimentation électrique d'une machine motrice et/ou contrôler l'électricité fournie par une machine génératrice.

Pour ce faire, on connaît notamment des ensembles dans lequel le codeur comprend au moins une piste magnétique associée à un organe tournant, par exemple un arbre de transmission, ainsi qu'un capteur comprenant un circuit imprimé présentant une face sur laquelle un composant sensible est implanté en présentant une surface de détection qui est disposée à l'opposé de ladite face, afin d'être en regard du codeur.

Pour éviter les chocs et/ou l'intrusion de corps étrangers, notamment de poussières, qui peuvent nuire à son bon fonctionnement, il est nécessaire de protéger le composant sensible. Pour ce faire, on connaît des ensembles dans lequel le composant sensible est enfermé dans un boîtier réalisé en un matériau amagnétique, par exemple en plastique et/ou un aluminium, afin de ne pas perturber la détection magnétique du champ émis par le codeur.

Cette solution ne donne pas entière satisfaction, en ce qu'elle ne permet pas d'obtenir une distance d'entrefer suffisamment petite, notamment inférieure à 1 mm, pour garantir une bonne détection du champ magnétique émis par le codeur.

En effet, le montage d'un tel boîtier nécessite un jeu suffisant à l'interface entre le composant sensible et le codeur, notamment pour y loger une épaisseur du boîtier mais également pour tenir compte des jeux mécaniques nécessaires au montage dudit boîtier.

L'invention vise à résoudre les problèmes de l'art antérieur en proposant notamment un capteur d'un champ magnétique émis par un codeur, dans lequel le composant sensible peut être protégé de façon efficace à une distance d'entrefer réduite pour pouvoir fiabiliser sa détection dudit champ magnétique.

A cet effet, selon un premier aspect, l'invention propose un capteur comprenant un composant sensible apte à détecter le champ magnétique délivré par le déplacement d'un codeur disposé à distance d'entrefer, ledit capteur comprenant un circuit imprimé présentant une face sur laquelle ledit composant sensible est implanté en présentant une surface de détection qui est disposée à l'opposé de ladite face, ledit circuit imprimé comprenant une couche de revêtement d'au moins une partie de la face, la couche de revêtement formant une cavité dans laquelle le composant sensible est disposé, l'épaisseur de ladite couche de revêtement étant telle que la surface de détection est affleurante d'une ouverture de la cavité débouchant dans la face libre de ladite couche de revêtement, ladite ouverture étant occultée par un film de protection qui est disposé de sorte à recouvrir la surface de détection.

Selon un second aspect, l'invention propose un ensemble comprenant un organe monté en déplacement par rapport à une structure fixe, dans lequel un codeur est solidaire de l'organe mobile en étant apte à délivrer un champ magnétique représentatif de son déplacement, ledit ensemble comprenant en outre un tel capteur dont le circuit imprimé est associé à la structure fixe en disposant la surface de détection du composant sensible à distance d'entrefer du codeur au travers du film de protection.

D'autres particularités et avantages de l'invention apparaîtront dans la description qui suit, faite en référence aux figures jointes, dans lesquelles :
[Fig.1a] et
[Fig.1b] sont des représentations schématiques d'un ensemble selon un mode de réalisation de l'invention, respectivement en vue de côté (figure 1b) et en coupe suivant le plan A-A de la figure 1b (figure 1a) ;
[Fig.2] est un agrandissement de la figure 1a centré sur le capteur ;
[Fig.3] est un agrandissement en coupe suivant le plan B-B de la figure 1b, centré sur l'association du capteur à la structure fixe ;
[Fig.4a] et
[Fig.4b] sont des représentations schématiques en coupe longitudinale de la structure d'un capteur selon respectivement un mode de réalisation de l'invention.

En relation avec ces figures, on décrit un ensemble comprenant un organe 1 monté en déplacement par rapport à une structure fixe 2. En particulier, l'ensemble peut être intégré dans une machine, et comprend un organe mobile 1 sous forme d'un arbre qui est entraîné en rotation par rapport à la structure fixe 2.

Selon une application, la machine est alimentée en électricité pour actionner l'entraînement en déplacement de l'organe mobile 1, par exemple dans le but de motoriser un dispositif appartenant à une unité d'aide à la conduite d'un véhicule automobile, ou un véhicule à guidage automatique. En particulier, la machine électrique peut constituer un moteur synchrone à aimant permanent. Dans une autre application, la machine génère de l'électricité par déplacement de l'organe mobile 1.

A cet effet, la machine électrique peut comprendre un système d'alimentation électrique qui est géré pour :
- dans le cas d'une machine motrice, pouvoir piloter le déplacement de l'organe mobile 1, notamment en relation avec le couple et la vitesse de déplacement ; et/ou
- dans le cas d'une machine génératrice, contrôler son alimentation électrique, notamment en relation avec la fréquence de la tension électrique générée.

Pour ce faire, la machine électrique est équipée d'un système de détermination d'au moins une information relative au déplacement de l'organe mobile 1, notamment agencé pour délivrer une information relative à la position dudit organe mobile, ladite information étant utilisée par le système d'alimentation électrique pour sa gestion. L'information déterminée peut aussi être relative à la vitesse, à l'accélération et/ou au sens de déplacement de l'organe mobile 1.

Le système de détermination comprend un codeur 3 solidaire en déplacement de l'organe mobile 1, ledit codeur étant apte à délivrer un champ magnétique représentatif de son déplacement, et un capteur 4 solidaire de la structure fixe 2, qui comprend un composant sensible 5 apte à détecter le champ magnétique délivré par le déplacement dudit codeur disposé à distance d'entrefer D.

En particulier, le capteur 4 peut comprendre un dispositif de détermination d'au moins une information relative au déplacement du codeur 3.

Selon une réalisation, permettant une résolution optimale de l'information déterminée, le codeur 3 présente une piste magnétique formée d'une succession de paires de pôles magnétiques Nord et Sud qui sont disposées pour délivrer un champ magnétique pseudo sinusoïdal, le composant sensible 5 comprenant au moins deux éléments sensibles disposés à distance de lecture de la piste magnétique du codeur 3.

Selon une réalisation connue notamment du document EP-1 403 622, le codeur 3 peut présenter une piste magnétique secondaire permettant en particulier de déterminer une information de position absolue. En particulier, le caractère bi-piste du codeur permet de générer une pulse de référence par paire de pôles d'un moteur, ce qui permet de le piloter plus facilement.

A titre d'exemple, le codeur 3 peut être formé d'un aimant sur lequel les pôles magnétiques sont constitués, notamment en formant au moins une piste aimantée 6. En particulier, l'aimant peut comprendre une matrice, par exemple réalisée à base d'un matériau plastique ou élastomère, dans laquelle sont dispersées des particules magnétiques, notamment des particules de ferrite ou de terres rares comme le NdFeB, qui sont aimantées suivant la succession de pôles.

Les éléments sensibles du capteur 4 sont aptes à émettre chacun un signal qui est fonction du champ délivré par la piste 6 du codeur 3, le dispositif de détermination comprenant :
- un dispositif de traitement des signaux émis par les éléments sensibles qui est agencé pour fournir deux signaux en quadrature et de même amplitude qui sont chacun représentatifs du champ magnétique ; et
- à partir desdits signaux en quadrature, un dispositif de calcul de l'information relative au déplacement de l'organe mobile.

Selon une réalisation, le document WO-2006/064169 décrit un capteur agencé pour délivrer deux signaux respectivement SIN et COS en quadrature et de même amplitude qui sont chacun représentatifs du champ magnétique délivré par la piste 6 du codeur 3.

Le document DE 10 2017 212039 A1 divulgue également un capteur apte à détecter un champ magnétique.

En particulier, le composant 5 peut comprendre au moins un élément sensible, notamment choisi parmi les sondes magnétosensibles, par exemple à effet Hall, et/ou les sondes à base de magnétorésistances à effet tunnel (TMR), de magnétorésistances anisotropes (AMR) ou de magnétorésistances géantes (GMR).

Par ailleurs, le dispositif de calcul peut comprendre des moyens d'interpolation permettant d'augmenter la résolution de l'information relative au déplacement du codeur 3.

Le capteur 4 comprend un circuit imprimé 7 présentant une face 8 sur laquelle le composant sensible 5 est implanté, en présentant une surface de détection 9 qui est disposée à l'opposé de ladite face. Le circuit imprimé 7 est associé à la structure fixe 2, en disposant la surface de détection 9 à distance d'entrefer D du codeur 3.

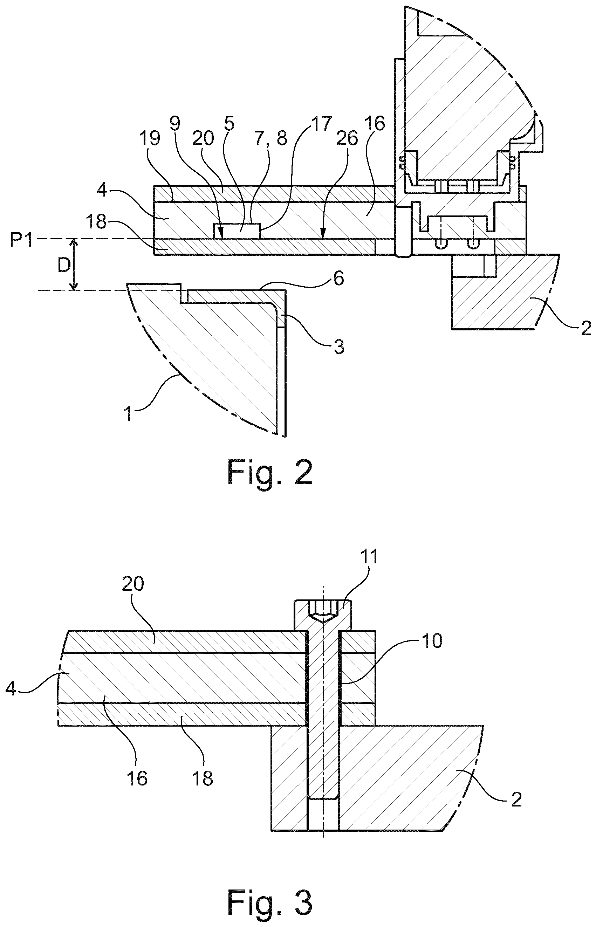

Dans les modes de réalisation représentés, le circuit imprimé 7 est équipé de moyens d'association 10 adaptés pour permettre un tel positionnement de la surface de détection 9 par rapport au codeur 3. En particulier, le circuit imprimé 7 est percé d'au moins un orifice d'association 10 sur toute son épaisseur, afin de permettre le passage d'une vis 11 pour son association à la structure fixe 2, comme représenté sur la figure 3.

Le circuit imprimé 7 peut comprendre plusieurs couches conductrices 12a, 12b, par exemple à base d'un matériau tel que le cuivre, le composant sensible 5 étant implanté sur une couche externe 12a.

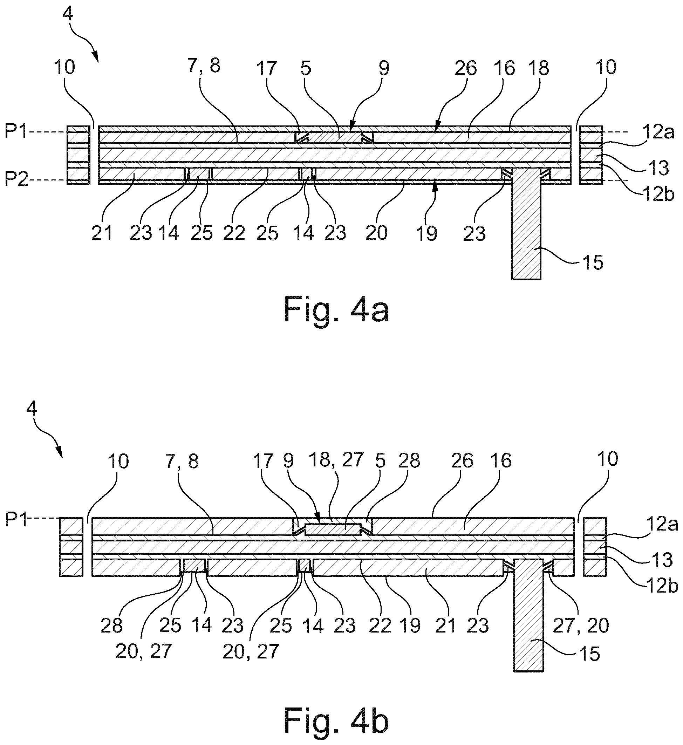

Sur les figures 4a et 4b, le circuit imprimé 7 comprend deux couches conductrices 12a, 12b séparées par une couche isolante 13, notamment à base d'une résine, ainsi que deux autres composants électroniques 14 implantés sur la couche externe 12b opposée à la couche conductrice 12a portant le composant sensible 5.

Le circuit imprimé 7 intègre en outre un connecteur 15 pour une prise de connexion du capteur 4, ledit connecteur étant associé à la couche externe 12b opposée au composant sensible 5 sur les figures 4a et 4b.

Le circuit imprimé 7 comprend une couche 16 de revêtement d'au moins une partie de la face 8 sur laquelle le composant sensible 5 est implanté.

La couche de revêtement 16 forme une cavité 17 dans laquelle le composant sensible 5 est disposé, l'épaisseur de ladite couche de revêtement étant telle que la surface de détection 9 est affleurante d'une ouverture de la cavité 17 débouchant dans la face libre 26 de ladite couche de revêtement, ladite ouverture étant occultée par un film de protection 18 qui est disposé de sorte à recouvrir la surface de détection 9.

Ainsi, on peut disposer la surface de détection 9 à une distance D du codeur 3 qui est suffisamment réduite pour permettre une bonne détection par le composant sensible 5 du champ magnétique émis par ledit codeur, et ce tout en assurant une protection de ladite surface, qui est disposée à distance d'entrefer D dudit codeur au travers du film 18.

De façon avantageuse, le film de protection 18 présente une épaisseur qui est inférieure à 1 mm, notamment en étant inférieure à 0,5 mm, ce qui permet de limiter la distance d'entrefer D, mais également de faciliter la détection du champ magnétique par le composant sensible au travers dudit film.

Le circuit imprimé 7 peut également présenter une face 19 opposée qui porte un film de protection 20, ce qui permet notamment de protéger d'éventuels autres composants électroniques 14 implantés sur cette face 19.

Sur les figures 4a et 4b, la couche conductrice 12b portant les autres composants électroniques 14 comprend :
- une couche de revêtement 21 associée sur sa face externe 22, en formant trois cavités 23 dans chacune desquelles un composant électronique 14 ou le connecteur 15 est disposé, la surface libre 25 de chaque composant 14 étant affleurante avec l'ouverture de la cavité 23 correspondante ;
- un film de protection 20 occultant chacune desdites ouvertures, de sorte à recouvrir chaque composant électronique 14.

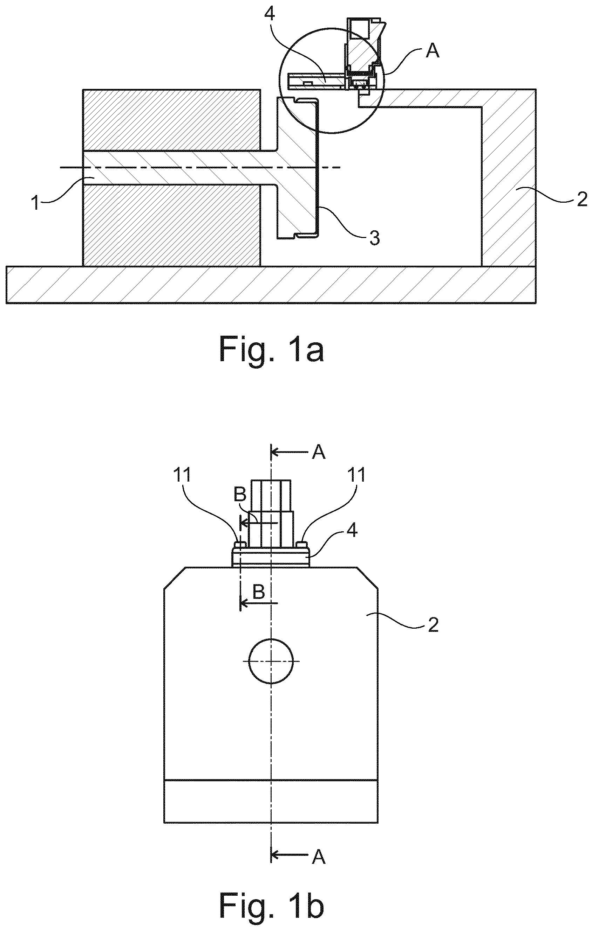

Sur les figures 1a, 2, 3 et 4a, un film de protection 18, 20 est associé, par exemple par collage, sur la face libre 26, 19 de chaque couche de revêtement 16, 21, en venant recouvrir l'ouverture de la cavité 17 dans laquelle est disposé le composant sensible 5 et les éventuelles cavités 23 contenant d'autres composants électroniques 14 ou le connecteur 15. En particulier, les films 18, 20 représentés sur ces figures recouvrent chacun la totalité de la face libre 26,19 de la couche de revêtement 16, 21 correspondante.

Cet agencement permet de maîtriser facilement l'épaisseur de la protection recouvrant le composant électronique 5, 14, notamment le composant sensible 5, en choisissant un film 18, 20 d'épaisseur réduite, par exemple inférieure à 0,3 mm, et en l'associant à la couche de revêtement 16, 21 au moyen d'un film de colle d'épaisseur modérée, par exemple inférieure à 0,2 mm.

Pour ne pas interférer avec le champ magnétique émis par le codeur 3, les films 18, 20, notamment le film 18 recouvrant le composant sensible 5, sont réalisés en un matériau amagnétique, par exemple de type aluminium ou polycarbonate. Par ailleurs, le matériau composant les films 18, 20 peut être choisi afin de permettre des opérations supplémentaires sur lesdits films, par exemple une sérigraphie ou une impression, ainsi que leur perçage pour former l'orifice 10 et/ou pour laisser passer le connecteur 15.

En relation avec les figures 2 et 4a, la surface de détection 9 est disposée dans le plan P1 de la surface libre 26 de la couche de revêtement 16. De même, sur la figure 4a, les surfaces libres 25 des autres composants électroniques sont disposées dans le plan P2 de la surface libre 19 de l'autre couche de revêtement 21.

Sur la figure 4b, chaque cavité 17, 23 est comblée par un matériau 27 d'enrobage du composant sensible 5, du connecteur 15 ou des autres composants électroniques 14, en formant le film de protection 18, 20 entre la surface de détection 9 ou la surface libre 25 du composant 5, 14 correspondant et la surface libre 28 dudit matériau d'enrobage.

Le matériau d'enrobage 27 comprend une résine amagnétique, notamment à base de polyuréthane, d'époxy ou de silicone. Par ailleurs, pour faciliter le repérage du composant sensible 5 et/ou des composants électroniques 14 de l'autre face 22, la résine peut être teinte d'une couleur adaptée, notamment de manière à être translucide ou transparente.

La surface libre 28 du matériau d'enrobage 27 du composant sensible 5 est disposée dans le plan P1 de la surface libre 26 de la couche de revêtement 16, la surface de détection 9 étant alors en retrait dudit plan d'une distance réduite correspondant à l'épaisseur du film de protection 18.

## Revendications

1. Capteur (4) comprenant un composant sensible (5) apte à détecter le champ magnétique délivré par le déplacement d'un codeur (3) disposé à distance d'entrefer (D), ledit capteur comprenant un circuit imprimé (7) présentant une face (8) sur laquelle ledit composant sensible est implanté en présentant une surface de détection (9) qui est disposée à l'opposé de ladite face, ledit circuit imprimé comprenant une couche (16) de revêtement d'au moins une partie de la face (8), ledit capteur étant **caractérisé en ce que** la couche de revêtement (16) forme une cavité (17) dans laquelle le composant sensible (5) est disposé, l'épaisseur de ladite couche de revêtement étant telle que la surface de détection (9) est affleurante d'une ouverture de la cavité (17) débouchant dans la face libre (26) de ladite couche de revêtement, ladite ouverture étant occultée par un film de protection (18) qui est disposé de sorte à recouvrir la surface de détection (9).

2. Capteur (4) selon la revendication 1, **caractérisé en ce que** le film de protection (18) est associé sur la face libre (26) de la couche de revêtement (16) en venant recouvrir l'ouverture de la cavité (17).

3. Capteur (4) selon la revendication 2, **caractérisé en ce que** le film de protection (18) s'étend sur la totalité de la face libre (26) de la couche de revêtement (16).

4. Capteur (4) selon l'une des revendications 2 ou 3, **caractérisé en ce que** la surface de détection (9) est disposée dans le plan (P1) de la surface libre (26) de la couche de revêtement (16).

5. Capteur (4) selon l'une quelconque des revendications 2 à 4, **caractérisé en ce que** le film de protection (18) est réalisé en matériau amagnétique de type aluminium ou polycarbonate.

6. Capteur (4) selon la revendication 1, **caractérisé en ce que** la cavité (17) est comblée par un matériau (27) d'enrobage du composant sensible (5) en formant le film de protection (18) entre la surface de détection (9) et la surface libre (28) dudit matériau d'enrobage.

7. Capteur (4) selon la revendication 6, **caractérisé en ce que** la surface libre (28) du matériau d'enrobage (27) est disposée dans le plan (P1) de la surface libre (26) de la couche de revêtement (16).

8. Capteur (4) selon l'une des revendications 6 ou 7, **caractérisé en ce que** le matériau d'enrobage (27) comprend une résine amagnétique à base de polyuréthane, d'époxy ou de silicone.

9. Capteur (4) selon l'une quelconque des revendications 1 à 8, **caractérisé en ce que** le film de protection (18) présente une épaisseur qui est inférieure à 1 mm, notamment en étant inférieure à 0,5 mm.

10. Capteur (4) selon l'une quelconque des revendications 1 à 9, **caractérisé en ce que** le circuit imprimé (7) est équipé de moyens (10) d'association permettant de positionner la surface de détection (9) du composant sensible (5) à distance d'entrefer (D) d'un codeur (3).

11. Capteur (4) selon la revendication 10, **caractérisé en ce que** le circuit imprimé (7) est percé d'au moins un orifice d'association (10).

12. Capteur (4) selon l'une quelconque des revendications 1 à 11, **caractérisé en ce que** le circuit imprimé (7) présente une face opposée (19) qui porte un film de protection (20).

13. Capteur (4) selon l'une quelconque des revendications 1 à 12, **caractérisé en ce que** le circuit imprimé (7) comprend plusieurs couches conductrices (12a, 12b), le composant sensible (5) étant implanté sur une couche externe (12a).

14. Capteur (4) selon l'une quelconque des revendications 1 à 13, **caractérisé en ce que** le composant sensible (5) comprend au moins deux éléments sensibles qui sont aptes à émettre chacun un signal qui est fonction du champ délivré par le codeur (3), ledit capteur comprenant un dispositif de détermination d'au moins une information relative au déplacement du codeur (3), ledit dispositif de détermination comprenant :
- un dispositif de traitement des signaux émis par les éléments sensibles qui est agencé pour fournir deux signaux en quadrature et de même amplitude qui sont chacun représentatifs du champ magnétique ; et
- à partir desdits signaux en quadrature, un dispositif de calcul de l'information relative au déplacement du codeur (3).

15. Ensemble comprenant un organe (1) monté en déplacement par rapport à une structure fixe (2), dans lequel un codeur (3) est solidaire de l'organe mobile (1) en étant apte à délivré un champ magnétique représentatif de son déplacement, ledit ensemble comprenant en outre un capteur (4) selon l'une quelconque des revendications 1 à 14 dont le circuit imprimé (7) est associé à la structure fixe (2) en disposant la surface de détection (9) du composant sensible (5) à distance d'entrefer (D) du codeur (3) au travers du film de protection (18).

## Patentansprüche

1. Sensor (4), der eine empfindliche Komponente (5) umfasst, die imstande ist, das durch die Verlagerung eines in Spaltentfernung (D) angeordneten Kodierers (3) bereitgestellte Magnetfeld zu ermitteln, wobei der Sensor eine gedruckte Schaltung (7) umfasst, die eine Fläche (8) aufweist, auf der die empfindliche Komponente implementiert ist, indem sie eine Detektionsoberfläche (9) aufweist, die der Fläche gegenüberliegend angeordnet ist, wobei die gedruckte Schaltung eine Schicht (16) umfasst, die mindestens einen Teil der Fläche (8) überzieht, wobei der Sensor **dadurch gekennzeichnet ist, dass** die Überzugsschicht (16) einen Hohlraum (17) bildet, in dem die empfindliche Komponente (5) angeordnet ist, wobei die Dicke der Überzugsschicht derart ist, dass die Detektionsoberfläche (9) mit einer Öffnung des Hohlraums (17) bündig ist, die in der freien Fläche (26) der Überzugsschicht ausmündet, wobei die Öffnung von einer Schutzfolie (18) verdeckt ist, die derart angeordnet ist, dass die Detektionsoberfläche (9) bedeckt ist.

2. Sensor (4) nach Anspruch 1, **dadurch gekennzeichnet, dass** die Schutzfolie (18) der freien Fläche (26) der Überzugsschicht (16) derart zugeordnet ist, dass sie die Öffnung des Hohlraums (17) bedeckt.

3. Sensor (4) nach Anspruch 2, **dadurch gekennzeichnet, dass** sich die Schutzfolie (18) über die Gesamtheit der freien Fläche (26) der Überzugsschicht (16) erstreckt.

4. Sensor (4) nach einem der Ansprüche 2 oder 3, **dadurch gekennzeichnet, dass** die Detektionsoberfläche (9) in der Ebene (P1) der freien Oberfläche (26) der Überzugsschicht (16) angeordnet ist.

5. Sensor (4) nach einem der Ansprüche 2 bis 4, **dadurch gekennzeichnet, dass** die Schutzfolie (18) aus amagnetischem Material vom Typ Aluminium oder Polycarbonat hergestellt ist.

6. Sensor (4) nach Anspruch 1, **dadurch gekennzeichnet, dass** der Hohlraum (17) mit einem Beschichtungsmaterial (27) der empfindlichen Komponente (5) gefüllt ist, indem die Schutzfolie (18) zwischen der Detektionsoberfläche (9) und der freien Oberfläche (28) des Beschichtungsmaterials gebildet wird.

7. Sensor (4) nach Anspruch 6, **dadurch gekennzeichnet, dass** die freie Oberfläche (28) des Beschichtungsmaterials (27) in der Ebene (P1) der freien Oberfläche (26) der Überzugsschicht (16) angeordnet ist.

8. Sensor (4) nach einem der Ansprüche 6 oder 7, **dadurch gekennzeichnet, dass** das Beschichtungsmaterial (27) ein amagnetisches Harz auf der Basis von Polyurethan, Epoxid oder Silikon umfasst.

9. Sensor (4) nach einem der Ansprüche 1 bis 8, **dadurch gekennzeichnet, dass** die Schutzfolie (18) eine Dicke aufweist, die kleiner als 1 mm ist, insbesondere kleiner als 0,5 mm ist.

10. Sensor (4) nach einem der Ansprüche 1 bis 9, **dadurch gekennzeichnet, dass** die gedruckte Schaltung (7) mit Zuordnungsmitteln (10) ausgestattet ist, die erlauben, die Detektionsoberfläche (9) der empfindlichen Komponente (5) in Spaltentfernung (D) von einem Kodierer (3) zu positionieren.

11. Sensor (4) nach Anspruch 10, **dadurch gekennzeichnet, dass** die gedruckte Schaltung (7) von mindestens einer Zuordnungsöffnung (10) durchbohrt ist.

12. Sensor (4) nach einem der Ansprüche 1 bis 11, **dadurch gekennzeichnet, dass** die gedruckte Schaltung (7) eine gegenüberliegende Fläche (19) aufweist, die eine Schutzfolie (20) trägt.

13. Sensor (4) nach einem der Ansprüche 1 bis 12, **dadurch gekennzeichnet, dass** die gedruckte Schaltung (7) mehrere leitende Schichten (12a, 12b) umfasst, wobei die empfindliche Komponente (5) auf einer äußeren Schicht (12a) implementiert ist.

14. Sensor (4) nach einem der Ansprüche 1 bis 13, **dadurch gekennzeichnet, dass** die empfindliche Komponente (5) mindestens zwei empfindliche Elemente umfasst, die imstande sind, jeweils ein Signal zu senden, das von dem vom Kodierer (3) bereitgestellten Feld abhängt, wobei der Sensor eine Vorrichtung zum Bestimmen von mindestens einer Information umfasst, die sich auf die Verlagerung des Kodierers (3) bezieht, wobei die Bestimmungsvorrichtung umfasst:
- eine Vorrichtung zum Verarbeiten der von den empfindlichen Elementen gesendeten Signale, die eingerichtet ist, um zwei Quadratursignale mit derselben Amplitude zu senden, die jeweils für das Magnetfeld repräsentativ sind; und
- ausgehend von den Quadratursignalen, eine Vorrichtung zum Berechnen der Information, die sich auf die Verlagerung des Kodierers (3) bezieht.

15. Anordnung, die ein Organ (1) umfasst, das im Verhältnis zu einer festen Struktur (2) verlagernd angebracht ist, wobei ein Kodierer (3) mit dem beweglichen Organ (1) fest verbunden ist, indem er imstande ist, ein Magnetfeld bereitzustellen, das für seine Verlagerung repräsentativ ist, wobei die Anordnung ferner einen Sensor (4) nach einem der Ansprüche 1 bis 14 umfasst, dessen gedruckte Schaltung (7) der festen Struktur (2) zugeordnet ist, indem die Detektionsoberfläche (9) der empfindlichen Komponente (5) in Spaltentfernung (D) von dem Kodierer (3) durch die Schutzfolie (18) angeordnet ist.

## Claims

1. A sensor (4) comprising a sensitive component (5) capable of detecting the magnetic field delivered by the movement of an encoder (3) arranged at an air gap distance (D), said sensor comprising a printed circuit board (7) having a face (8) on which said sensitive component is implanted while having a detection surface (9) which is arranged opposite said face, said printed circuit board comprising a layer (16) coating at least one portion of the face (8), said sensor being **characterised in that** the coating layer (16) forms a cavity (17) in which the sensitive component (5) is arranged, the thickness of said coating layer being such that the detection surface (9) is flush with an opening of the cavity (17) opening into the free face (26) of said coating layer, said opening being concealed by a protective film (18) which is arranged so as to cover the detection surface (9).

2. The sensor (4) according to claim 1, **characterised in that** the protective film (18) is associated with the free face (26) of the coating layer (16) by covering the opening of the cavity (17).

3. The sensor (4) according to claim 2, **characterised in that** the protective film (18) extends over the entirety of the free face (26) of the coating layer (16).

4. The sensor (4) according to one of claims 2 or 3, **characterised in that** the detection surface (9) is arranged in the plane (P1) of the free surface (26) of the coating layer (16).

5. The sensor (4) according to any one of claims 2 to 4, **characterised in that** the protective film (18) is made of a non-magnetic material of the aluminium or polycarbonate type.

6. The sensor (4) according to claim 1, **characterised in that** the cavity (17) is filled with a material (27) for encapsulating the sensitive component (5) while forming the protective film (18) between the detection surface (9) and the free surface (28) of said coating material.

7. The sensor (4) according to claim 6, **characterised in that** the free surface (28) of the coating material (27) is arranged in the plane (P1) of the free surface (26) of the coating layer (16).

8. The sensor (4) according to one of claims 6 or 7, **characterised in that** the coating material (27) comprises a non-magnetic resin based on polyurethane, epoxy or silicone.

9. The sensor (4) according to any one of claims 1 to 8, **characterised in that** the protective film (18) has a thickness which is smaller than 1 mm, in particular by being smaller than 0.5 mm.

10. The sensor (4) according to any one of claims 1 to 9, **characterised in that** the printed circuit board (7) is equipped with association means (10) allowing positioning the detection surface (9) of the sensitive component (5) at an air gap distance (D) from an encoder (3).

11. The sensor (4) according to claim 10, **characterised in that** the printed circuit board (7) is pierced with at least one association orifice (10).

12. The sensor (4) according to any one of claims 1 to 11, **characterised in that** the printed circuit board (7) has an opposite face (19) which carries a protective film (20) .

13. The sensor (4) according to any one of claims 1 to 12, **characterised in that** the printed circuit board (7) comprises several conductive layers (12a, 12b), the sensitive component (5) being implanted over an outer layer (12a).

14. The sensor (4) according to any one of claims 1 to 13, **characterised in that** the sensitive component (5) comprises at least two sensitive elements each capable of emitting a signal which depends on the field delivered by the encoder (3), said sensor comprising a device for determining at least one piece of information relating to the movement of the encoder (3), said determining device comprising:
- a device for processing the signals emitted by the sensitive elements which is arranged to supply two signals in phase-quadrature and with the same amplitude each representative of the magnetic field; and
- from said quadrature-phase signals, a device for computing information relating to the movement of the encoder (3).

15. An assembly comprising a member (1) mounted movable relative to a fixed structure (2), in which an encoder (3) is secured to the movable member (1) while being able to deliver a magnetic field representative of its movement, said assembly further comprising a sensor (4) according to any one of claims 1 to 14 whose printed circuit board (7) is associated with the fixed structure (2) by arranging the detection surface (9) of the sensitive component (5) at an air gap distance (D) from the encoder (3) through the protective film (18).
